(19) Europäisches Patentamt
European Patent Office
Office européen des brevets

(11) EP 0 811 252 B1

(12) EUROPÄISCHE PATENTSCHRIFT

(45) Veröffentlichungstag und Bekanntmachung des Hinweises auf die Patenterteilung:
26.05.1999 Patentblatt 1999/21

(51) Int Cl.6: **H01L 41/083**, H01L 41/09

(86) Internationale Anmeldenummer:
PCT/DE96/00301

(21) Anmeldenummer: 96903894.2

(22) Anmeldetag: 23.02.1996

(87) Internationale Veröffentlichungsnummer:
WO 96/26551 (29.08.1996 Gazette 1996/39)

(54) **ULTRASCHALLANTRIEBSELEMENT**

ULTRASONIC DRIVING ELEMENT

ELEMENT D'ENTRAINEMENT A ULTRASONS

(84) Benannte Vertragsstaaten:
CH DE ES FR GB IT LI SE

(30) Priorität: 23.02.1995 DE 19506203
13.02.1996 DE 19605214

(43) Veröffentlichungstag der Anmeldung:
10.12.1997 Patentblatt 1997/50

(73) Patentinhaber: ROBERT BOSCH GMBH
70442 Stuttgart (DE)

(72) Erfinder:
• LINDEMANN, Gert
D-72805 Lichtenstein (DE)
• SCHMOLL, Klaus-Peter
D-74251 Lehrensteinsfeld (DE)
• KEUPER, Gerhard
D-71229 Leonberg (DE)
• WALLASCHEK, Jörg
D-33106 Paderborn (DE)

(56) Entgegenhaltungen:
EP-A- 0 424 609          EP-A- 0 556 821
EP-A- 0 584 775

• PATENT ABSTRACTS OF JAPAN Bd. 013, Nr. 164 (E-745) 19 April 1989 & JP,A,63 316 675 (MITSUBISHI ELECTRIC CORP) 23 Dezember 1988
• PATENT ABSTRACTS OF JAPAN Bd. 013, Nr. 164 (E-745) 19 April 1989 & JP,A,63 316 676 (MITSUBISHI ELECTRIC CORP) 23 Dezember 1988
• PATENT ABSTRACTS OF JAPAN Bd. 012, Nr. 158 (E-608) 13 Mai 1988 & JP,A,62 272 575 (MATSUSHITA ELECTRIC WORKS LTD) 26 November 1987

## Beschreibung

Stand der Technik

Die Erfindung geht aus von einem Antriebselement nach der Gattung des Hauptanspruchs. Der piezoelektrische Effekt wird seit langem technisch genutzt. Zur Vergrößerung des Stellweges werden häufig in Multilayer-Technik aufgebaute Elemente angeboten, beispielsweise von der Firma PHYSIK INSTRUMENTE im Katalog 107 von 1990. Sie bestehen aus mehreren übereinander gelagerten, dünnen piezoelektrischen Schichten mit einer Stärke von z.B. 20 bis 500 µm, zwischen die jeweils eine Elektrodenschicht zur elektrischen Kontaktierung eingebracht ist. Solche Elemente erzeugen in einer ersten Ausführungsform mit einer großen Zahl übereinanderangeordneter Schichten durch Anlegen einer Gleichspannung eine Hubbewegung, beziehungsweise durch Anlegen einer Wechselspannung eine Hubschwingung. Eine zweite Ausführungsform mit jeweils zwei, seitlich gelagerten Schichten liefert, unter Nutzung des sekundären piezoelektrischen Effektes, bei Anlegen einer Gleichspannung eine Biegebewegung, bei Anlegen einer Wechselspannung eine Biegeschwingung. Eine über den maximalen Hub bzw. die maximale Biegung hinausgehende Verstellwirkung kann mit diesen Elementen nicht erzielt werden.

Ein rotatorischer Ultraschallantrieb mit unbegrenztem Verstellbereich ist von der Firma SHINSEI bekannt. Er basiert auf einer ringförmigen Piezokeramik, welche in zwei separat ansteuerbare Anregungsbereiche mit je 8 Segmenten unterteilt ist. Durch Anlegen zweier zeitlich um 90 Grad gegeneinander verschobener Wechselspannungen an die beiden Anregungsbereiche wird in einem mit dem Piezoring verklebten Stator eine Biegewanderwelle erzeugt. Über eine Reibschicht ist diese zum Antrieb eines Rotors nutzbar. Zahlreiche Verbesserungsvorschläge für nach dem Prinzip des SHINSEI-Motors arbeitende Wanderwellenmotoren sind bekannt geworden.

Das Prinzip der Wanderwelle eignet sich gut für rotatorische Bewegungen, für Linearantriebe ist es dagegen ungeeignet. Versuche, einen linearen Ultraschall-Wanderwellenmotor durch Aufschneiden des im SHINSEI-Motor verwendeten Piezoringes zu realisieren, schlugen fehl. Ursache hierfür sind insbesondere an den Enden der aufgeschnittenen Piezostruktur auftretende Reflexionen, welche den mit der Wanderwelle transportierten Energiefluß, und damit die gesamte Bewegung stören. Vielfältige Versuche, die Reflexionen zu verhindern und eine Wanderwelle auf einem endlichen Piezobalken zu erzeugen, erbrachten bisher keine technisch verwertbaren Lösungen.

Bekannt gewordene Lösungen zur Realisierung eines linearen Antriebsmechanismus beruhen auf der Verwendung von diskreten Einzelaktoren, welche durch Anlegen geeigneter Spannungen derart angeregt werden, daß für einen Oberflächenpunkt eine elliptische Bewegung entsteht. Gemäß einer auf der EP 297 574 bekannten Lösung sollen hierzu zwei senkrecht zueinander stehende Längsschwingungen, gemäß einer aus der US 4 763 776 bekannten Lösung zwei zueinander senkrecht stehende Biegeschwingungen eingesetzt werden.

Der Erfindung liegt die Aufgabe zugrunde, einen gut handhabbaren Ultraschallmotor anzugeben, welcher für lineare Verstellbewegungen geeignet ist.

Diese Aufgabe wird gelöst durch einen Ultraschallantriebselement mit den kennzeichnenden Merkmalen des Hauptanspruchs. Ein erfindungsgemäßes Ultraschallantriebselement bietet den Vorteil, einfach und in großer Formenvielfalt herstellbar zu sein. Der Antrieb kann sowohl in der Weise erfolgen, daß die Oberflächenpunkte, die gegen das anzutreibende Teil gedrückt werden, elliptische Bewegungen ausführen, als auch durch einen Stößelmechanismus, wobei die Oberflächenpunkte eine Stößelbewegung gegen das abzutreibende Teil ausführen. In beiden Fällen ist leicht eine Bewegungsumkehr möglich. Ein erfindungsgemäßes Ultraschallantriebselement weist daneben auch die für das Ultraschallantriebsprinzip typischen Vorteile auf. Insbesondere kann der Antrieb direkt, d.h. ohne Getriebe erfolgen. Es sind einerseits höhe Kräfte in der Größenordnung von $10^2$ N als auch andererseits kleine Geschwindigkeiten in einer Größenordnung von 10 mm/s möglich. Der benötigte Bauraum ist in Bezug auf die abgegebene Leistung klein.

Tragendes Prinzip für das erfindungsgemäße Antriebselement ist, die elektrische Kontaktierung der piezoelektrischen Schichten so zu gestalten, daß eine gezielte Anregung bestimmter mechanischer Schwingungen möglich ist. In einer ersten vorteilhaften Ausführungsform sind die Kontaktierungsschichten jeweils in zwei Teilbereiche gegliedert, in denen je ein Elektrode ausgebildet ist, welche separat ansteuerbar ist. Durch Anlegen von in geeigneter Weise gegeneinander phasenverschobenen Wechselspannungen an die Elektroden können die piezoelektrischen Schichten wahlweise zu Längs-, Biege- oder elliptischen Schwingungen angeregt werden.

Eine alternative Möglichkeit zur Anregung von Längs-bzw. Biegeschwingungen in nebeneinander liegenden Bereichen einer piezoelektrischen Schicht sieht vor, Längsschwingungen beispielsweise im oberen Bereich eines Antriebselementes, Biegeschwingungen im unteren Bereich anzuregen. Eine weitere Alternative sieht vor, Längsschwingungen beispielsweise in den inneren Bereichen eines Antriebselements, Biegeschwingungen im äußeren Bereich eines Antriebselements anzuregen.

Zur Realisierung eines besonders effektiven Antriebes kann die Anregung der Längs-/Biegeschwingungen resonant erfolgen. Um dabei einen unerwünschten Energieaustausch zwischen beiden Schwingungsformen zu unterbinden, ist das Antriebselement zweckmäßig so dimensioniert, daß die Eigenfrequenzen der beiden Schwingungsformen weit auseinanderliegen. Vorteilhaft erfolgt die Dimensionierung so, daß das Verhältnis der Eigenfrequenzen zueinander ganzzahlig ist. Eine andere vorteilhafte Möglichkeit, die gleichzeitig resonante Anregung von Längs- und Biegeschwingungen zu ermöglichen, sieht vor, die Biegeschwingungen im zweiten Biegemode anzuregen. Dabei ergibt sich neben der gleichzeitigen resonanten Anregbarkeit beider Schwingungsformen zusätzlich der Vorteil einer verringerten Geräuschentwicklung.

Als vorteilhaft hat es sich erwiesen, Antriebselemente in Form von mehreren zu Türmchen gestapelten piezoelektrischen Schichten auszuführen, welche zinnenartig nebeneinander angeordnet sind und aufeinander abgestimmt angesteuert werden. Es lassen sich so insbesondere große Kräfte aufbringen. Mit Hilfe des Türmchenkonzeptes lassen sich daneben in einfacher Weise auch rotatorische Antriebe realisieren, indem die Türmchen ringförmig angeordnet werden. Eine weitere vorteilhafte Ausführungsform sieht nebeneinander angeordnete Türmchen vor, welche zusätzlich durch türmchenartige Brückenstapel, die eine kleinere Höhe aufweisen, verbunden sind. Türmchen und Brückenstapel werden bei dieser Ausführungsform jeweils nur zu Längsschwingungen angeregt.

Bei einer weiteren vorteilhaften Ausgestaltung ist jeweils nur ein Teil einer jeden piezoelektrischen Schicht elektrisch kontaktiert, während der übrige Teil elektrisch nicht kontaktiert ist. Durch die so gegebene unsymmetrische Kontaktierung lassen sich sowohl Biege- als auch Hubschwingungen in einfacher Weise mittels nur einer einzigen Wechselspannung anregen.

Eine vorteilhafte Weiterbildung dieser Ausführung sieht vor, jede Schicht in drei getrennt kontaktierte Teilbereiche zu gliedern, wobei die beiden äußeren so angesteuert werden, daß sie gegenläufig schwingen. Der mittlere Bereich wird je nach gewünschter Bewegungsrichtung in Phase mit dem einen oder dem anderen Außenbereich angesteuert.

Ausführungsbeispiele für ein erfindungsgemäßes Ultraschallantriebselement werden nachfolgend unter Bezugnahme auf die Zeichnung näher erläutert.

Zeichnung

Es zeigen Figur 1 den Aufbau eines vorgeschlagenen Vielschichtantriebselementes, Figur 2 alternative Ausgestaltungen eines aus mehreren Türmchen aufgebauten Antriebselementes, Figur 3 verschiedene Aufteilungen der Anregungsbereiche, Figur 4 mögliche Formen von aus mehreren Türmchen aufgebauten Antriebselementen, Figur 5 den Bewegungsablauf eines aus Türmchen und Brückenstapeln aufgebauten Antriebselementes, Figur 6 eine Ausgestaltung eines aus Türmchen und Brückenstapeln aufgebauten Antriebselementes, Figur 7 ein in V-Form aufgebautes Antriebselement, Figur 8 ein einphasig anregbares Antriebselement mit den zugehörigen Bewegungsverhältnissen, Figur 9 ein einphasig anregbares Antriebselement mit drei Elektroden je Schicht, Figur 10 weitere mögliche Gestaltungen eines Antriebselements, Figur 11 eine Anordnung zum Antrieb eines Gegenstandes, Figur 12 ein zu Anregung des zweiten Biegemodes geeignetes Antriebselement.

Beschreibung

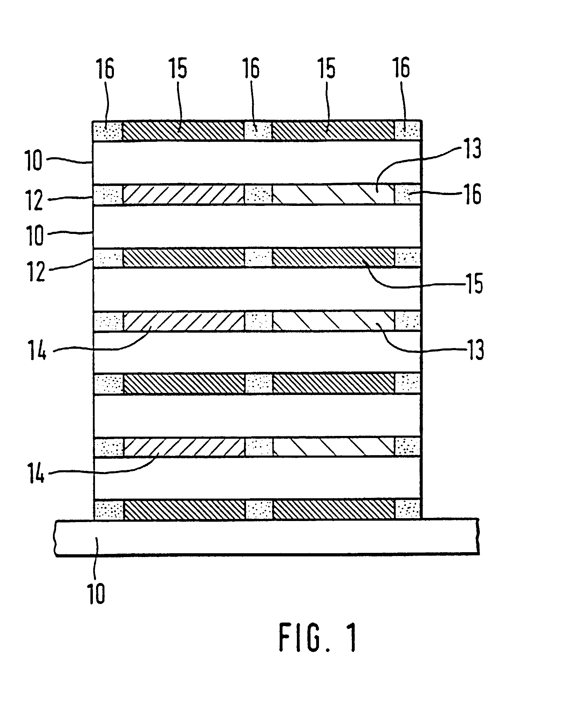

Figur 1 veranschaulicht das Aufbauprinzip eines vorgeschlagenen Antriebselementes. Es entsteht durch abwechselnde Übereinanderschichtung von Schichten 10 aus piezoelektrischem Material, im folgenden als Piezoschichten bezeichnet, und Kontaktierungsschichten 12 zur elektrischen Kontaktierung der Piezoschichten 10. Die Kontaktierungsschichten 12 sind jeweils in wenigstens zwei elektrisch getrennte Bereiche gegliedert. Sie setzen sich aus Bereichen von elektrisch leitendem Elektrodenmaterial, sowie aus Bereichen von nichtleitendem Füllmaterial zusammen. Ersteres definiert Elektroden 13, 14, 15 zur Anregung der Piezoschichten 10. Das Füllmaterial ist an den soll, und dient insbesondere zur Gliederung der Stellen 16 eingebracht, wo sich keine Elektrode befinden Kontaktierungsschichten 12. Über nicht dargestellte elektrische Zuleitungen sind an die in den Kontaktierungsschichten 12 ausgebildeten Elektroden 13 eine erste Spannung $U_1$, an die Elektroden 14 eine zweite Spannung $U_2$, und an die Elektroden 15 Erdpotential $U_G$ angelegt.

Eine Schichtanordnung 10 bis 16 gemäß Figur 1 läßt sich wie folgt herstellen: Ein geeignetes Grundmaterial, zum Beispiel Blei-Zirkonat-Titanat ($Pb(Zr_xTi_{1-x})O_3$); mit x-0,4...0,6), oder alternativ ein den komplexen ternären Systemen entstammendes Material wie etwa $PbZiO_3$-$Pb(Me_{1/3}Nb_{2/3})O_3$ mit Me=Mg,Mn, Co, wobei das Pb teilweise durch Ba oder Sr substituiert sein kann, wird zunächst zu einem feinen Pulver verarbeitet. Dieses wird mit einem organischen Bindermaterial, Weichmachern und Lösungsmitteln auf wässriger oder organischer Basis zu einer Dispersion, dem sogenannten Schlicker verrührt. Der Schlicker wird sodann mittels einer Gießvorrichtung zu einer Folie vergossen; in einem sich anschließenden Trocknungskanal wird das Lösungsmittel ausgedampft. Das Ergebnis ist eine, sich insbesondere durch eine große Flexibilität auszeichnende Folie, die sogenannte Grünfolie. Auf die Grünfolie werden nun vorzugsweise durch Siebdruck flächige Elektroden aufgebracht. Durch nachfolgendes Stapeln, Pressen und Schneiden der Folien wird die gewünschte Stapel-Struktur mit innenliegenden Elektroden erhalten. Aus dem so im Grünzustand fertigen Multilayer wird der Binder ausgebrannt, anschließend wird im selben Brand gesintert. Der fertige Piezokeramikkörper kann schließlich mit Hilfe der innenliegenden Elektroden polarisiert werden.

Ein gemäß Figur 1 aufgebautes Antriebselement wird entsprechend einer ersten Variante zweiphasig nichtresonant angeregt. An die Elektrodenpaare 13/15 bzw. 14/15 werden dabei jeweils zwei in der Phase um 90 Grad gegeneinander verschobene Wechselspannungen $U_1$, $U_2$ angelegt, mit z.B. folgender Form:

$$U_1 = U_0 * \sin(\omega t) \text{ und } U_2 = U_0 * \cos(\omega t)$$

oder in anderer Darstellung:

$$U_1 = U_0 * \sin(\omega t - 45°) \text{ und } U_2 = U_o * \sin(\omega t + 45°),$$

mit $U_0$ = Amplitude. Die Anregung erfolgt typischerweise hochfrequent im Ultraschallbereich mit Frequenzen von z.B. $f = \omega/2\pi > 20000$ Hz. Sie erfolgt nichtresonant, d.h. die Frequenz der elektrischen Anregung ist ungleich den mechanischen Eigenfrequenzen des Antriebselementes. Letztere liegen dabei in der Regel höher als die Frequenz der Anregung, die Anregung erfolgt unterkritisch. Das Antriebselement folgt in diesem Fall der Frequenz der Anregung unmittelbar ohne Phasenverzug. Durch die beiden Spannungen $U_1$, $U_2$ werden im Antriebselement zumindest zwei verschiedene Schwingungen angeregt. Sie überlagern sich im Antriebselement und bewirken, daß die Punkte der Oberfläche des Antriebselementes eine elliptische Bewegung ausführen. Der Durchlaufsinn der Ellipse hängt dabei davon ab, welche der Spannungen $U_1$ bzw. $U_2$ der anderen um 90° voreilt. Durch Umdrehen einer der Spannungen wird eine Bewegungsumkehr erreicht.

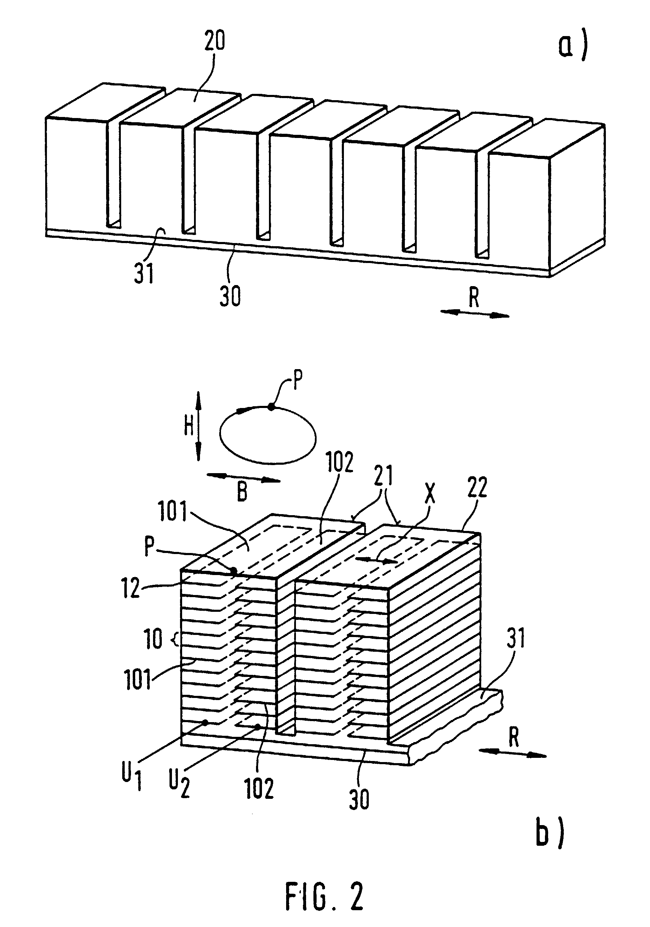

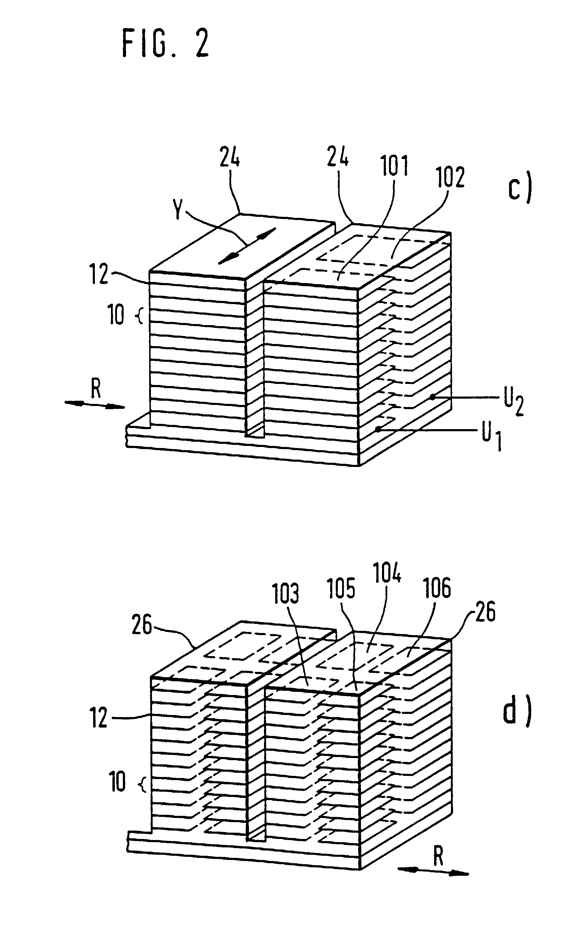

Figur 2a zeigt eine erste vorteilhafte Ausführungsform eines in Vielschichttechnik aufgebauten Antriebselementes. Es besteht aus mehreren in Form von Türmchen 20 ausgeführten Stapeln von piezoelektrischen -bzw. Kontaktierungsschichten. Durch einen Sockel 31, welcher zumindest eine, gegebenenfalls auch mehrere durchgehende Piezoschichten 30 enthält, sind alle Türmchen 20 miteinander verbunden. Jeweils mehrere zinnenartig nebeneinander entlang einer Erstreckungsrichtung R angeordnete Türmchen 20 bilden in Form eines Multi-Piezo-Aktors ein Antriebselement.

Wie in Figur 2b veranschaulicht, sind die zwischen den Piezoschichten 10 angeordneten Kontaktierungsschichten 12 jeweils in zwei Bereiche 101, 102 gegliedert, die jeweils eine separat ansteuerbare Elektrode bilden. Zur Vereinfachung der Beschreibung werden die beiden Bereiche 101, 102 nachfolgend als linker bzw. rechter Bereich bezeichnet. Jeweils an die in den linken Bereichen 101 der Kontaktierungsschichten 12 ausgebildeten Elektroden eines Türmchens 22 wird eine Spannung $U_1$, an die rechten Elektroden 102 eine Spannung $U_2$ angelegt. Werden, unter der zur Vereinfachung der Beschreibung hier wie im folgenden stets zugrundegelegten Annahme, daß die Piezoschichten 10 in gleicher Richtung polarisiert sind, die linken Elektroden 101 und die rechten Elektroden 102 jeweils mit gleichen Spannungen ohne Phasenverschiebung angeregt, führen die Türmchen 22 eine Längsschwingung aus. Werden die Elektroden 101 bzw. 102 andererseits mit gleichen, jedoch um 180° gegeneinander phasenverschoben Spannungen, wie z.B. $U_1 = -\sin(\omega t)$, $U_2 - \sin(\omega t)$, angeregt, entsteht eine Biegeschwingung. Um gleichzeitig beide Schwingungsformen anzuregen, werden an die linken Elektroden 101 bzw. die rechten Elektroden 102 um 90° phasenverschobene Spannungen angelegt, z.B.

$$U_1 = \sin(\omega t - 45°)$$

$$U_2 = \sin(\omega t + 45°)$$

Die dadurch gleichzeitig angeregten Längsschwingungen H bzw. Biegeschwingungen B überlagern sich und versetzen die Oberfläche 21 eines Türmchens 22 in eine elliptische Bewegung mit einer Komponente H senkrecht zur Oberfläche 21 des Türmchens 22 und einer Komponente B parallel zur Erstreckungsrichtung R der Türmchenreihe. Oberhalb des linken Türmchens der Figur 2b ist die resultierende elliptische Bewegung für einen Punkt P der Oberfläche des Türmchens 20 angedeutet. Die darin enthaltene Komponente parallel zur Oberfläche 21 des Türmchens 22 kann in bekannter Weise zum Antrieb eines zu bewegenden Gegenstandes genutzt werden. Entsprechend der angedeuteten Lage der Ellipse verläuft die Richtung X der resultierenden Bewegung eines angetriebenen Objekts dann parallel zur Erstreckungsrichtung R der Türmchenreihe, wie durch den Pfeil auf dem rechten Türmchen angedeutet.

Aufgrund der in jedem Türmchen 22 separat erfolgenden Schwingungsanregung erzeugt bereits ein einzelnes Türmchen eine lineare Bewegung. Durch Einsatz einer Türmchenreihe, wie sie in Figur 2a angedeutet ist, läßt sich bequem eine gewünschte Kraft einstellen, sie verbessert zudem die Bewegungslinearität.

Das in Figur 2 dargestellte Türmchenkonzept erlaubt eine Reihe vorteilhafter Varianten. So kann die Bereichseinteilung der Kontaktierungsschichten 12 nicht nur senkrecht zur Erstreckungsrichtung R der Türmchenreihe erfolgen, so daß eine Links/Rechts-Teilung entsteht, sondern auch, wie in Figur 2c dargestellt, parallel zu dieser Richtung, so daß eine Vorne/Hinten-Teilung entsteht. Dadurch wird, wie durch den Pfeil auf dem linken Türmchen 24 angedeutet, auch die Abtriebsrichtung Y gegenüber der bei einer Links-/Rechtsanordnung erhaltenen um 90° gedreht. Sie erfolgt dann senkrecht zur Erstreckungsrichtung R der Türmchenreihe.

Vorteilhaft kann es ferner sein, jede Kontaktierungsschicht 12 in vier Bereiche rechts vorn 105, rechts hinten 106, links vorn 103, links hinten 104, einzuteilen, wie in Figur 2d angedeutet. Auf diese Weise können sowohl Bewegungen parallel zur Erstreckungsrichtung R einer Reihe von Türmchen 26 als auch senkrecht dazu erzeugt werden. Durch entsprechende Ansteuerung lassen sich die Grundabtriebsrichtungen X, Y zu einer Gesamtbewegung in einer beliebigen Richtung in der Ebene parallel zur Türmchenoberfläche überlagern.

Die Vielfalt der möglichen Bewegungen läßt sich ferner durch eine feldartige Türmchenanordnung erweitern. Werden in einem solchen Feld beispielsweise 10 x 10 einzeln ansteuerbare Türmchen angeordnet, läßt sich ein darüber angetriebener Körper in zwei translatorische Raumrichtungen bewegen. Zusätzlich kann der translatorischen Bewegung eine Drehung um die zu den translatorischen Richtungen orthogonale Achse überlagert sein.

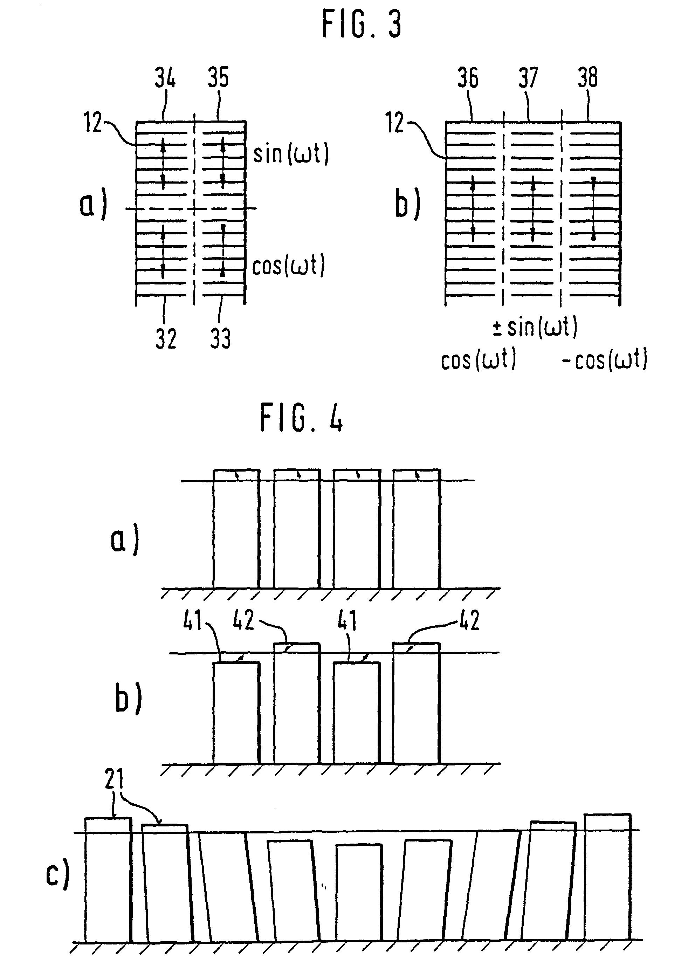

Gemäß einer weiteren Variante werden die Längs- und die Biegeschwingung nicht jeweils in einer Schicht, sondern in räumlich getrennten Schichten angeregt. Beispiele für diese Variante sind in Figur 3 wiedergegeben. Bei der in Figur 3a gezeigten Anordnung sind an die unteren Bereiche 32, 33 des Türmchens um 180° gegeneinander phasenverschobene Spannungen cos(ωt), -cos(ωt), an die oberen Bereiche 34, 35 phasengleiche, gegenüber den an den unteren Bereichen anliegenden um 90° phasenverschobene Spannungen sin(ωt) angelegt. Dadurch werden im unteren Teil des Türmchens Biegeschwingungen, angedeutet durch entgegengesetzte Doppelpfeile $\updownarrow\updownarrow$, im oberen Bereich Längsschwingungen, angedeutet durch gleichgerichtete Doppelpfeile $\updownarrow\updownarrow$ angeregt. Bei der in Figur 3b gezeigten Ausführungsform führt der mittlere Bereich 37 durch Anlegen einer Spannung sin(ωt) Längsschwingungen aus, während zwischen den Außenbereichen 36, 38 durch Anlegen von um 180° gegeneinander phasenverschobenen Spannungen cos(ωt), -cos(ωt) Biegeschwingungen angeregt werden.

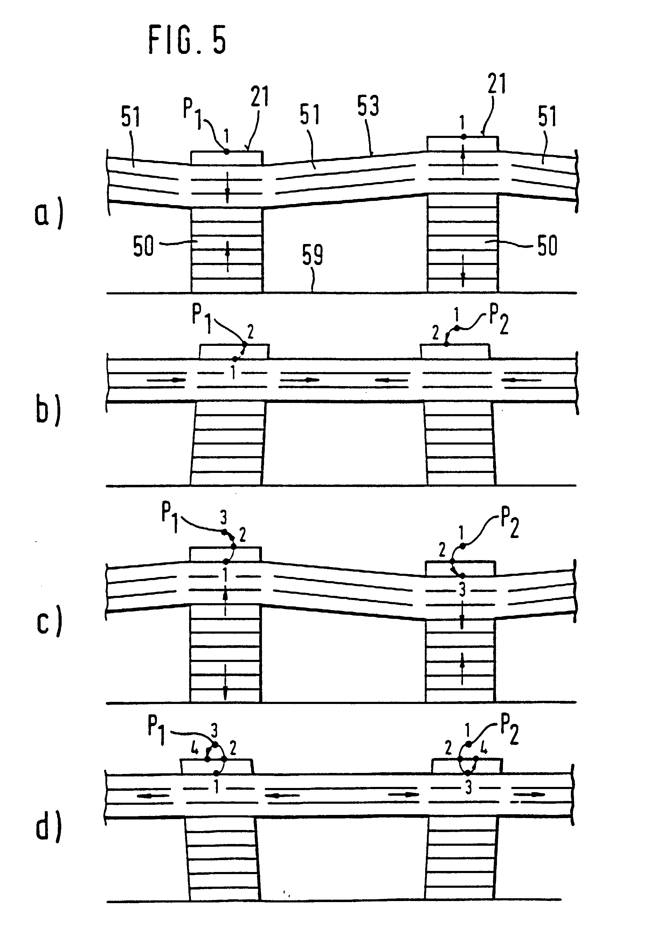

Verschiedene gleichwertige Möglichkeiten bestehen hinsichtlich der Ansteuerung eines mit mehreren Türmchen aufgebauten Antriebselementes. Neben einer in Figur 4a dargestellten genau gleichläufigen Anregung aller Türmchen können sie auch, wie in Figur 4b angedeutet, so angesteuert werden, daß benachbarte Türmchen 41, 42 sich gegenläufig verhalten. Während sich eine Hälfte der Türmchen 41 z.B. nach rechts oben bewegt und antreibt, befindet sich die andere Hälfte der Türmchen 42, welche aus den jeweils zwischen denen der ersten Hälfte liegenden gebildet wird, auf dem Rückweg nach links unten. Realisiert werden kann eine solche Ansteuerung durch Erhöhung der Zahl der Anregungszuleitungen von zwei auf vier - die hier nicht weiter berücksichtigten Massezuleitungen sind analog zu erhöhen -, oder aber günstiger durch eine geeignete Ausgestaltung der Elektroden und/oder der Polarisation der Piezoschichten, wobei dann unverändert nur zwei Zuleitungen erforderlich sind.

Eine weitere, in Figur 4c dargestellte Ansteuermöglichkeit besteht darin, die Türmchen so anzusteuern, daß ihre Oberflächen 21 eine zwangserregte Wanderwelle nachbilden.

Mit in Form von Türmchen ausgeführten Stapeln von piezoelektrischen- und Kontaktierungsschichten lassen sich desweiteren rotatorische Antriebe realisieren. Figur 4d zeigt eine in Form eines Kreisringes ausgeführte Türmchenreihe, bei der die Oberflächen 21 innenzylindrisch ausgerichtet sind. Die Anordnung gestattet insbesondere Drehbewegungen um eine konzentrisch angeordnete Achse 43.

Figur 4e zeigt eine Anordnung mit außenzylindrisch ausgerichteten Türmchenoberflächen 21. Die Anordnung gestattet insbesondere Bewegungen relativ zur Innenfläche eines umgebenden Zylinders 44.

Figur 4f zeigt als weitere mögliche Ausführungsform eine Kreisringanordnung, bei der die Oberflächen 21 der Türmchen radial in einer Ebene angeordnet sind. Mit der Anordnung lassen sich beliebige Bewegungen relativ zu der durch die Oberflächen 21 der Türmchen liegenden Ebene realisieren.

Eine weitere auf der Verwendung von Türmchen beruhende Ausführungsform des vorgeschlagenen Antriebselementes ist in Figur 5 dargestellt. Nebeneinander angeordnete Türmchen 50 sind dabei durch Brückenstapel 51 verbunden. Diese sind wie Türmchen aufgebaut, weisen aber eine niedrigere Stapelhöhe auf. Ihre Anordnung zwischen den Türmchen 50 erfolgt zweckmäßig so, daß sie weder das anzutreibende Element noch die Basis 59 berühren, auf welcher die Türmchen 50 gelagert sind. Die Elektroden der Brückenstapel 51 liegen senkrecht zur gewünschten Ausdehnungsrichtung, genutzt wird der sekundäre piezoelektrische Effekt der Querkontraktion. Polarisation und elektrisches Feld stehen dabei senkrecht auf der gewünschten Längsrichtung. Sowohl Türmchen 50 als auch Brückenstapel 51 werden jeweils zu Längsschwingungen angeregt, wobei die in den Bückenstapeln 51 angeregten Schwingungen orthogonal liegen zu den in den Türmchen 50 angeregten. Die Bewegungen von Türmchen 50 und Brückenstapeln 51 überlagern sich an den Oberflächen 21 der Türmchen 50 wiederum so, daß diese elliptische Bewegungen ausführen. Vier Stadien einer solchen Bewegung sind in den Figuren 5a - d dargestellt.

In dem in Figur 5a wiedergegebenen Bewegungsstadium hat sich das linke Türmchen 50 zusammengezogen, das rechte gedehnt, beide befinden sich jeweils am Umkehrpunkt. Die Brückenstapel 51 erfahren zu diesem Zeitpunkt einen Nulldurchgang, sind weder gestreckt noch gedehnt. Im zweiten Bewegungsstadium gemäß Figur 5b erfahren die Türmchen 50 einen Nulldurchgang, sie sind also weder gestreckt noch gedehnt. Der mittlere Brückenstapel 51 befindet sich am Umkehrpunkt nach einer Kontraktion, die beiden äußeren jeweils am Umkehrpunkt nach einer Dehnung.

Das dritte Stadium gemäß Figur 5c entspricht dem ersten gemäß Figur 5a, jedoch sind die Bewegungszustände der Türmchen vertauscht. Das linke hat sich gedehnt, das rechte zusammengezogen. Das vierte Stadium gemäß Figur 5d entspricht in analoger Weise dem zweiten, wobei jetzt die Bewegungszustände der Brückenstapel 51 vertauscht sind. Der mittlere befindet sich am Umkehrpunkt nach einer Drehung, die äußeren jeweils am Umkehrpunkt nach einer Kontraktion.

Auf den Oberflächen 21 der Türmchen liegende Punkte $P_1$ und $P_2$ beschreiben bei diesem Bewegungsablauf, wie in der Figur 5 veranschaulicht, jeweils elliptische Bewegungsbahnen. Eine besonders einfache Fertigung der in Figur 5 dargestellten Ausführungsform ist möglich, wenn Türmchen 50 und Brückenstapel 51 zunächst an den Oberflächen 21, 53 bündig abschließen, d.h. mit glatter Oberfläche hergestellt werden, und anschließend auf die Oberflächen 21 der Türmchen 50 eine Reibschicht aufgebracht wird, welche Kontakt zu einem anzutreibenden Element hat.

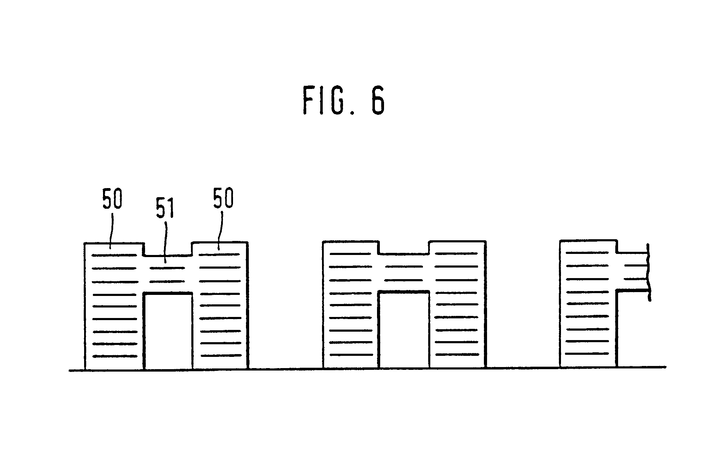

Figur 6 zeigt eine weitere Ausgestaltung einer Türmchen/Brückenstapelstruktur. Dabei ist ein Türmchen 50 jeweils mit einem benachbarten durch einen Brückenstapel 51 zu einer H-Struktur verbunden. Zu dem jeweils anderen benachbarten Türmchen 50 besteht keine Verbindung.

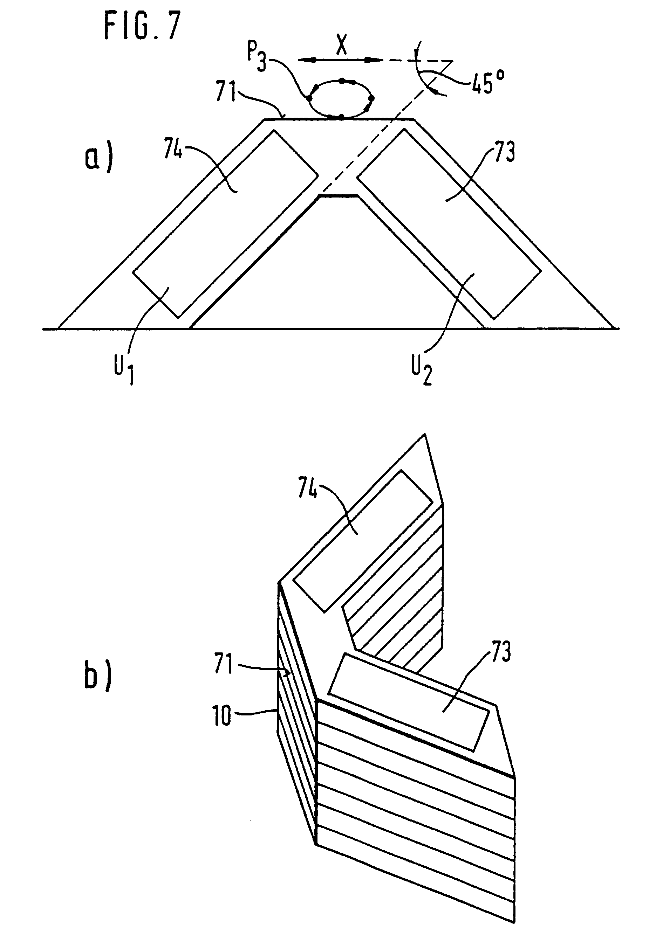

Gemäß einer weiteren in Figur 7 dargestellten Ausführungsform weist das Antriebselement eine V-Struktur auf. Jeweils in den Schenkeln der Struktur sind in den Kontaktierungsschichten Elektroden 73, 74 ausgebildet. Im dargestellten Beispiel beträgt der von den Schenkeln eingeschlossene Winkel etwa 90°. Zur Nutzung wird dieses V-förmige Element so angeordnet, daß die Schenkel mit den Elektroden 73, 74 jeweils um 45° gegen die durch einen Pfeil angedeutete Bewegungsrichtung X eines anzutreibenden Elementes geneigt sind. Der Antriebskontakt erfolgt über eine an der Stirnseite der V-Struktur ausgebildete Reibfläche 71. Genutzt wird der sekundäre piezoelektrische Effekt. Die Anregung der Elektroden 73, 74 in den Schenkeln erfolgt so, daß sie um 90° gegeneinander phasenverschobene Schwingungen ausführen. An der Reibfläche 71 resultiert daraus ein elliptischer Bewegungsverlauf, wie er in Figur 7a anhand von vier Bewegungsstadien für einen Punkt $P_3$ der Reiboberfläche 71 veranschaulicht ist.

Die Anregung der vorbeschriebenen Ausführungsformen eines Antriebselementes ist nicht auf Frequenzen im unterkritischen bzw. überkritischen Bereich, d.h. deutlich unter- oder oberhalb der Eigenfrequenzen der angeregten Schwingungsformen beschränkt, sondern kann auch in oder nahe der Eigenfrequenz einer der beteiligten Schwingungsformen im Resonanzbetrieb erfolgen. Folge einer solchen Resonanzanregung ist, daß die resonant schwingende Schwingungsform der Anregung um 90° nacheilt. Durch eine entsprechende Verschiebung der zugehörigen ersten Wechselspannung um 90° gegenüber der zweiten Wechselspannung kann dies ausgeglichen werden. Die Verschiebung führt in vorteilhafter Weise dazu, daß beide Schwingungsformen durch eine Anregung mit derselben Phasenlage angeregt werden können. Allerdings ist eine solche Resonanzanregung schwer abzustimmen und vergleichsweise störanfällig.

Eine weitere Möglichkeit der Ansteuerung eines vorgeschlagenen Antriebselementes besteht darin, die Ansteuerung mit einer Frequenz durchzuführen, welche zwischen den Eigenfrequenzen der relevanten Schwingungsformen liegt. Dabei eilt eine Schwingungsform der Anregung mit einer Phasenverschiebung von 180° (ideal), hinterher, die andere Schwingungsform folgt der Anregung (ideal) ohne Phasenversatz. Die Bewegung der Ellipse an der Oberfläche bleibt dadurch erhalten, ihr Umlaufsinn ist aber umgekehrt. Eine solche interkritische Anregung bietet deshalb eine vorteilhafte Möglichkeit, die Bewegungsrichtung umzukehren.

Grundsätzlich sehr vorteilhaft ist es, das Antriebselement so anzusteuern, daß gleichzeitig beide Schwingungsformen resonant angeregt werden. Dies ist möglich, wenn die Eigenfrequenzen der beteiligten relevanten Schwingungsmoden gleich sind, was insbesondere bei der anhand von Figur 7 dargestellten V-Form der Fall ist. Für beide Schwingungsformen ergibt sich dabei ideal ein Phasenversatz von 90°, die elliptische Bewegung der Oberfläche bleibt erhalten. Wegen der resonanzbedingten Amplitudenvergrößerung ist diese Ansteuervariante sehr attraktiv. Allerdings gilt wiederum, daß eine solche Anregungsfrequenz schwer abzustimmen ist. Zu vermeiden ist vor allem die Ausbildung von Schwebungen zwischen den angeregten Schwingungen. Dabei kommt es zu einem Energieaustausch zwischen den Schwingungen in Form einer überlagerten Schwebungs-Schwingung, entsprechend deren Frequenz die beien beteiligten Schwingungen phasenverzogen amplitudenmoduliert werden. Als Folge davon entartet die elliptische Bewegung der Oberfläche des Türmchens periodisch zu einer translatorischen Bewegung ohne Komponente in die gewünschte Antriebsrichtung.

Eine Möglichkeit zur Gestaltung eines Antriebselementes in der Weise, daß eine gleichzeitige Resonanzanregung aller an der Erzeugung der Oberflächenbewegung beteiligten Schwingungsformen möglich ist, besteht darin, die Türmchen geometrisch so zu dimensionieren, daß die Eigenfrequenzen der beteiligten Schwingungsformen voneinander ausreichend verschieden sind. Vorteilhaft erfolgt die geometrische Gestaltung dabei so, daß die zur Schwingungsanregung benötigten Frequenzen in einem ganzzeiligen Verhältnis, zum Beispiel 1 : 2, stehen. Für die Oberflächenpunkte eines Türmchens ergibt sich als Bewegungsform dann eine "8". Die im "oberen Teil" dieser Bewegung enthaltene Komponente parallel zur Oberfläche des Türmchens wird wie bei der elliptischen Bewegung zur Erzeugung eines Antriebsmomentes genutzt. Die Anregungsspannungen können auf die gleichen Elektroden aufgebracht werden und überlagern sich dort. Durch Steuerung der Phasendifferenz kann eine Bewegungsumkehr realisiert werden.

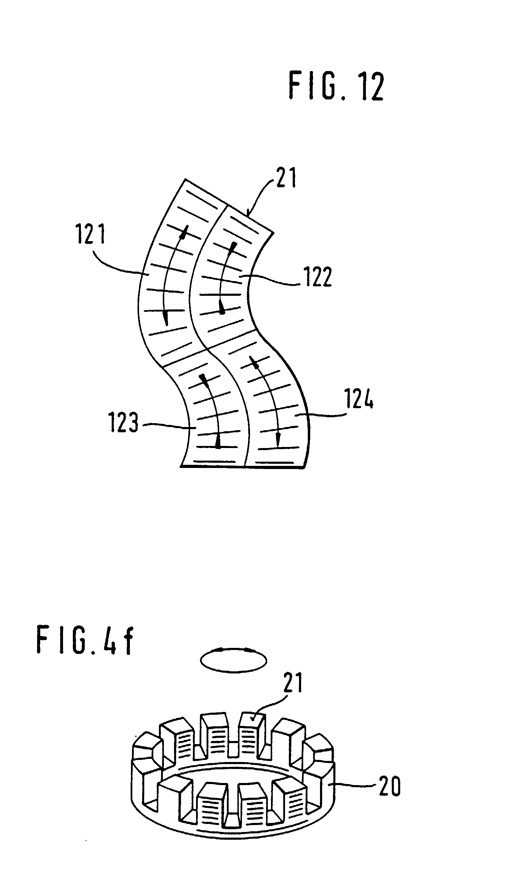

Eine andere Möglichkeit, die gleichzeitige Resonanzanregung mehrerer zur Erzeugung einer Oberflächenbewegung benötigter Schwingungen zu ermöglichen, ist in Figur 12 angedeutet. Die Biegeschwingungsanregung erfolgt dabei so, daß nicht der erste, sondern der zweite oder gegebenenfalls höhere Biegemode angeregt wird. Zwar weisen die höheren Biegemoden gegenüber dem ersten eine verminderte Amplitude auf, jedoch liegen ihre Eigenfrequenzen gegenüber jenen höher. Es können daher gleichzeitig resonant der zweite oder höhere Biegeschwindungsmode und eine Längsschwingung angeregt werden, wodurch der Nachteil der geringeren Amplitude des zweiten Biegemodes aufgewogen wird. Das Türmchen ist hierfür, ähnlich wie in Figur 3, in wenigstens vier Bereiche 121 bis 124 unterteilt, deren Ansteuerung jetzt so erfolgt, daß bezüglich der Biegeschwingung der zweite Biegemode angeregt wird. Bei vier Bereichen, 121 bis 124, wie in Figur 12 angenommen, wird dies erreicht, indem die diagonal einander gegenüberliegenden Bereiche 121, 124 beispielsweise mit einer Spannung $U_3 = +A \cdot \cos(\omega t)$, die beiden anderen einander diagonal gegenüberliegenden Bereiche 122, 123 mit $U_4 = -A \cdot \cos(\omega t)$, mit A = Amplitude der Anregungsspannung, angeregt werden. Dem überlagert wird noch jeweils die Anregungsspannung zur Anregung der Längsschwingung.

Die höhere Eigenfrequenz der zweiten Biegeschwingung hat zudem den Vorteil, daß sie in der Regel deutlich oberhalb der menschlichen Hörgrenze sowie desweiteren oberhalb der Hörgrenze einer Vielzahl von Tieren liegt. Für alle verringert sich dadurch die von dem Antrieb ausgehende Schallbelastung erheblich.

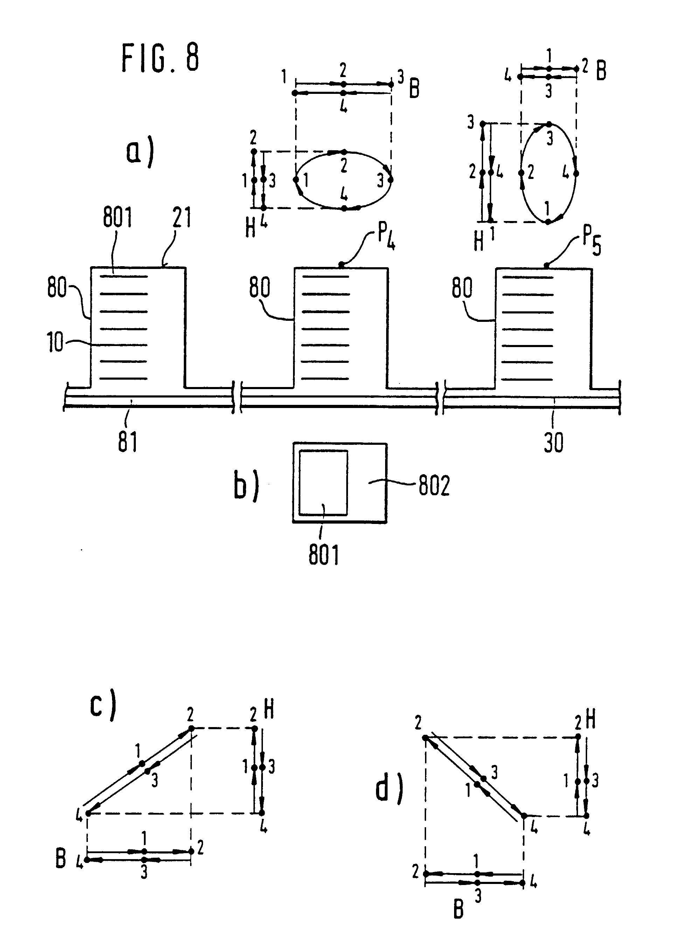

Figur 8 zeigt eine weitere Ausgestaltung des in Figur 1 dargestellten Aufbaugrundprinzips. Das wiedergegebene Antriebselement besteht wiederum aus mehreren zinnenartig nebeneinander angeordneten Türmchen 80, welche durch eine gemeinsame Basis 81 mit wenigstens einer durchgehenden piezoelektrischen Schicht 30 verbunden sind. Von den durch waagrechte Striche angedeuteten piezoelektrischen Schichten 10 ist jedoch jeweils nur ein Teilbereich 801 durch eine Elektrodenanordnung kontaktiert. Der jeweils andere Bereich 802 ist nicht elektrisch kontaktiert. Die Teilung der Schichten 10 in Bereiche 801, 802 erfolgt, wie in Figur 7b anhand eines Querschnitts durch ein Türmchen entlang einer Piezoschicht 10 dargestellt, asymmetrisch. Im Beispiel ist der elektrisch kontaktierte Bereich 801 größer als der nicht kontaktierte Bereich 802, er kann aber ebenso kleiner sein. Vorteil der Anordnung gemäß Figur 8 ist, daß sie mittels nur einer einzigen Steuerspannung ansteuerbar ist. Aufgrund der durch die ungleiche Bereichsteilung hervorgerufenen Asymetrie werden auch bei Anlegen von nur einer Wechselspannung zwei verschiedene Schwingungsformen angeregt. Die Türmchen 80 führen wiederum sowohl jeweils eine Hubbewegung H wie eine Biegebewegung B aus. Die Gestalt der dabei der an der Oberfläche 83 durch Überlagerung entstehenden Gesamtbewegung hängt von der Frequenz der zur Anregung eingesetzen Wechselspannung ab. Erfolgt die Anregung in oder nahe der Resonanzfrequenz der Biegeschwingung, und ist diese was im folgenden stets angenommen wird, kleiner als die Resonanzfrequenz der Längsschwingung, so eilt die Biegebewegung der Anregung um 90° nach. Die Längsschwingung ist unter der angenommenen Voraussetzung noch unterkritisch, sie hängt der Anregung nicht oder nur wenig nach. Als Folge bilden sich, obgleich die Anregung mit nur einer Wechselspannung erfolgt, wiederum sowohl eine Längsschwingung H als eine, dieser gegenüber um 90° phasenverschobene, Biegeschwingung B aus. Die Oberfläche 83 eines Türmchens 80 führt dadurch eine für einen Antrieb nutzbare elliptische Bewegung in einer Ebene senkrecht zur Oberfläche 21 der Türmchen 80 sowie senkrecht zur Teilungslinie zwischen den Bereichen 801 und 802 aus. Aufgrund der resonanten oder zumindest näherungsweise resonanten Anregung der Biegeschwingung ist deren Amplitude überhöht. Die von der Oberfläche 21 ausgeführte Bewegung entspricht daher einer abgeflachten Ellipse. Oberhalb des mittleren Türmchens 80 in Figur 8a ist ihr Zustandekommen anhand von vier Bewegungsstadien eines Oberflächenpunktes $P_4$ veranschaulicht. Dabei ist links neben der Ellipse der Einfluß der Hubschwingung H, oberhalb der Ellipse der Einfluß der Biegeschwingung B auf die resultierende Bewegungsbahn gezeigt.

Wird die Frequenz der Anregungsspannung in oder nahe der Resonanzfrequenz für die Längsschwingung gewählt, bewegt sich die Oberfläche 21 eines Türmchens 70 entlang einer senkrecht zur Oberfläche 73 längsgezogenen Ellipse. Die Biegeschwingung B eilt dann der Anregung - theoretisch - um 180°, die Längsschwingung H um 90° hinterher. Die resultierende Bewegungsbahn eines Oberflächenpunktes $P_5$ und ihr Zustandekommen durch Zusammenwirken von Hubschwingung H und Biegeschwingung B ist oberhalb des rechten Türmchens wiederum in Form von vier Bewegungsstadien dargestellt.

Erfolgt die Anregung entweder für beide Schwingungsformen unterkritisch, das heißt mit einer Frequenz, welche deutlich kleiner ist als die Resonanzfrequenzen der beiden Schwingungsformen, oder überkritisch, d.h. mit einer Frequenz, welche deutlich größer ist als die Resonanzfrequenzen der Schwingungsformen, führt die Oberfläche 21 des Türmchen 80 eine näherungsweise lineare Bewegung aus, welche beispielsweise von unten links nach oben rechts verlaufen kann. Figur 8c zeigt das Zustandekommen einer solchen Bewegung unter Einwirkung einer Hubschwingung H und einer Biegeschwingung B als Bewegungsstadiendiagramm. Eine Bewegung in umgekehrter Richtung, d.h. z.B. von links oben nach rechts unten, wird erreicht, indem die Anregung mit einer Frequenz erfolgt, welche zwischen den Eigenfrequenzen von Biege- und Längsschwingung liegt. Das Zustandekommen ist in Figur 8d veranschaulicht, aufgetragen sind wiederum die Bewegung eines Punktes unter dem Einfluß der Hubschwingung H, der Biegeschwingung B sowie der Resultierenden.

Durch geeignete Wahl der Frequenz der Anregungsspannung können mit einer Anordnung nach Figur 8 verschiedene Antriebsrichtungen bzw. Antriebsmechanismen realisiert werden. So läßt sich ein nach dem Stößelprinzip arbeitender Antrieb mit umkehrbarer Bewegungsrichtung durch entsprechend wechselnde Anregung mit einer Frequenz im unterkritischen Bereich sowie mit einer Frequenz im interkritischen Bereich realisieren. Wahl einer ersten Anregungsfrequenz in oder nahe der Eigenfrequenz einer der auftretenden Schwingungsmoden sowie einer zweiten Frequenz im interkritischen Bereich liefert ein in einer Bewegungsrichtung mit Hilfe einer elliptischen Aktorbewegung, in der anderen Richtung nach dem Stößelprinzip arbeitenden Antrieb.

Die Ansteuerung der einzelnen Türmchen 70 eines Antriebselementes kann in gleicher Weise erfolgen wie anhand von Figur 4 für zweiphasig nichtresonant angeregte Türmchen beschrieben.

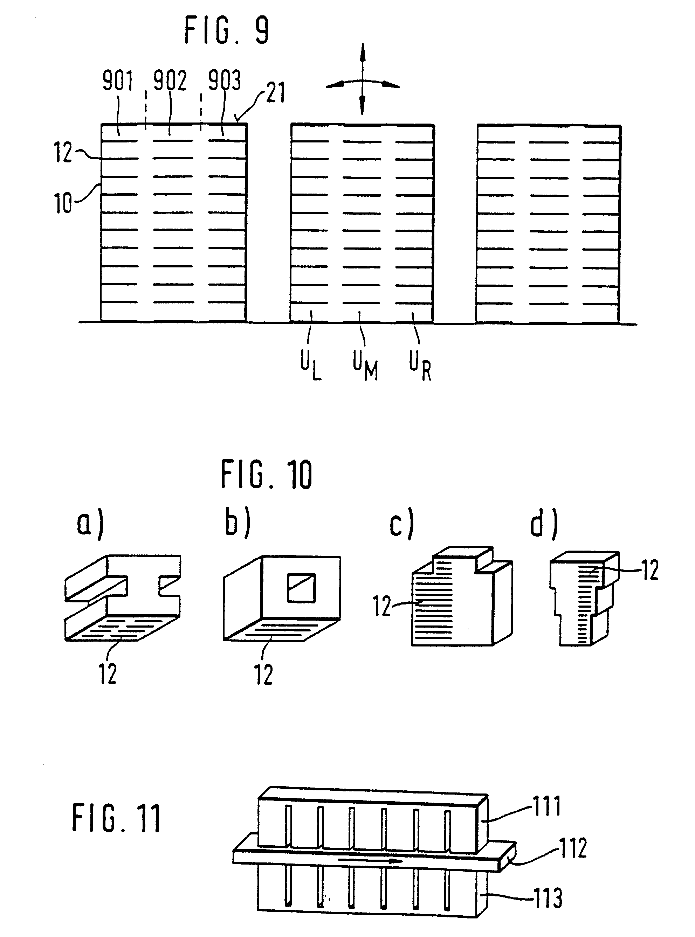

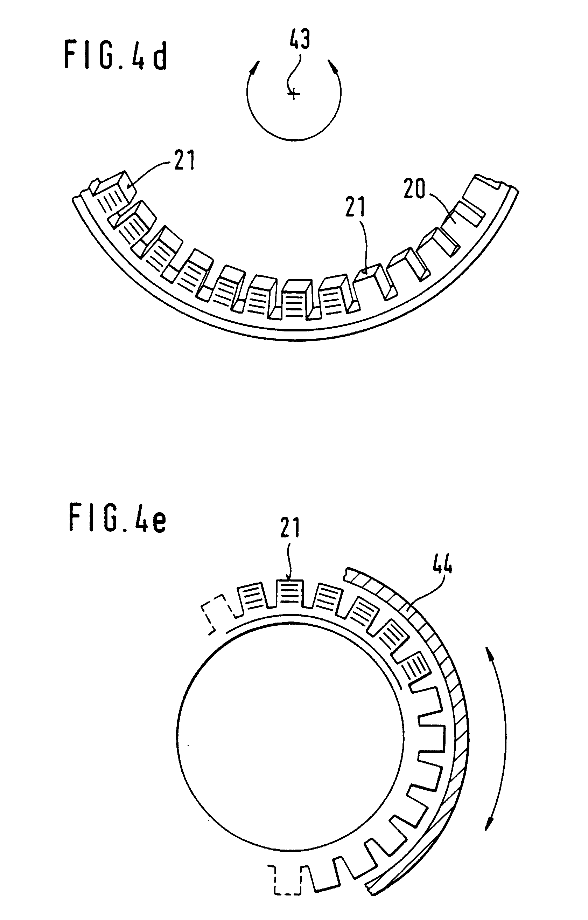

Eine weitere Ausführungsform eines einphasig steuerbaren Antriebselementes zeigt Figur 9. Hier sind die Schichten 10 jeweils in drei Bereiche 901, 902, 903 unterteilt. Die Ansteuerung erfolgt derart, daß die beiden äußeren Bereiche 801, 803 jeweils entgegengesetzt angesteuert werden, das heißt mit $U_L = + U$ und $U_R = - U$, wenn $U - U_0 \sin (\omega t)$. Der mittlere Bereich 802 wird abhängig von der gewünschten resultierenden Bewegungsrichtung so wie einer der Außenbereiche 801, 803 angesteuert, das heißt mit $U_M = U_R$ für einen Abtrieb nach links bzw. mit $U_M = U_L$ für Abtrieb nach rechts. Dies kann durch einfache Umschaltung in der Elektronik bewirkt werden. Es genügt daher wiederum eine Anregespannung. Die Anregung erfolgt, unter der Annahme, daß die Eigenfrequenz der Biegeschwingung kleiner ist als die der Längsschwingung, vorzugsweise in oder nahe der Eigenfrequenz der Biegeschwingung. Es bildet sich in gleicher Weise, wie anhand Figur 8 beschrieben, eine elliptische Bewegung der Oberfläche 91 aus. Durch Wechsel der Ansteuerung des mittleren Teiles 902 ist die Umlaufrichtung der resultierenden Bewegungsellipse umgekehrbar.

Die Formgebung der Antriebselemente ist desweiteren in einem weiten Rahmen frei gestaltbar. Beispiele für Türmchen mit frei gestalteter Geometrie der Schichten 10 zeigen die Figuren 10a und 10b, für Türmchen mit über die Höhe veränderlichem Schichtquerschnitt die Figuren 10c und 10d.

Lagerung des Antriebselementes und Prinzip der Kraftübertragung auf das anzutreibende Teil sind hier nicht beschrieben. Im Prinzip sind alle bekannten Methoden möglich. Eine beispielhafte Lösung für einen Antrieb mittels zweier Antriebselemente 1001, 1002 in Form von Türmchenreihen zeigt Figur 11. Das anzutreibende Teil 1000 befindet sich zwischen den Antriebselementen 1001, 1002, welche es von zwei Seiten antreiben. Zur sicheren Einhaltung eines ausreichenden Anpreßdruckes kann die dargestellte Anordnung durch eine federnde Klammer gegen das anzutreibende Teil 1000 gedrückt sein. Die Lagerung der Anordnung 1001, 1002, kann dabei beispielsweise schwimmend auf dem zu bewegenden Teil 1000 erfolgen.

## Patentansprüche

1. Ultraschallantriebselement mit mehreren, zu einem Stapel übereinanderangeordneten Schichten aus piezoelektrischem Material, zwischen denen sich jeweils eine, in mindestens zwei Teilbereiche gegliederte Kontaktierungsschicht befindet, wobei jeder Teilbereich jeweils eine die angrenzenden piezoelektrischen Schichten (10) kontaktierende Elektrode (13, 14, 15) aufweist, an die jeweils eine Betriebs-Wechselspannung anlegbar ist, welche eine Oberfläche (21) des Schichtenstapels zu mechanischen Schwingungen anregen, die eine Bewegungskomponente parallel zur Ebene dieser Oberfläche beinhalten, dadurch gekennzeichnet, daß zumindest an einen Teil der Elektroden (13, 14, 15) Wechselspannungen angelegt sind, welche den Schichtenstapel zu Längsschwingungen (H) anregen.

2. Antriebselement nach Anspruch 1, dadurch gekennzeichnet, daß an einen Teil (34, 35, 37) der piezoelektrischen Schichten (10) Wechselspannungen zum Anregen von Längsschwingungen (H), an den übrigen Teil (32, 33, 36, 38) Wechselspannungen zum Anregen vcn Biegeschwingungen (B) angelegt sind.

3. Antriebselement nach Anspruch 1, dadurch gekennzeichnet, daß an die Elektroden (101, 102) gegeneinander phasenverschobene Wechselspannungen ($U_1$, $U_2$) angelegt sind, welche in dem Schichtenstapel (22, 24) gleichzeitig Längsund Biegeschwingungen (H, B) anregen.

4. Ultraschallantriebselement mit mehreren, zu einem Stapel übereinanderangeordneten Schichten aus piezoelektrischem Material, zwischen denen sich jeweils eine Kontaktierungsschicht zum Anlegen einer Betriebsspannung befindet, wobei die Kontaktierungsschichten (12) in mindestens zwei Teilbereiche gegliedert sind, wovon einer eine die angrenzenden piezoelektrischen Schichten (10) kontaktierende Elektrode (801) aufweist) dadurch gekennzeichnet, daß die Teilbereiche ungleich geteilt sind, der jeweils zweite Teilbereich elektrisch nicht kontaktiert ist, und die Ansteuerung der Elektrode (801) mit einer Wechselspannung erfolgt, die in dem Stapel gleichzeitig eine Hubbewegung (H) und eine Biegebewegung (B) anregt.

5. Antriebselement nach Anspruch 1, dadurch gekennzeichnet, daß der Schichtenstapel in wenigstens vier Bereiche (121, 122, 123, 124) unterteilt ist, wobei an die Elektroden jeweils einander diagonal gegenüberliegende Bereiche (121, 124; 122, 123) phasenverschobene Wechselspannungen (U3, U4) angelegt sind, welche in dem Schichtenstapel den zweiten Mode einer Biegeschwingung anregen.

6. Antriebselement nach Anspruch 1 oder 4, dadurch gekennzeichnet, daß die piezoelektrischen Schichten (10) in Stapeln (20, 22, 24, 26) nach Art von Türmchen (20) angeordnet sind, welche nebeneinander zinnenartig auf wenigstens einer gemeinsamen piezoelektrischen Grundschicht (30) angeordnet sind und aufeinander abgestimmt angesteuert werden.

7. Antriebselement nach Anspruch 6, dadurch gekennzeichnet, daß die Türmchen (20) ringförmig angeordnet sind.

8. Antriebselement nach Anspruch 6, dadurch gekennzeichnet, daß alle Türmchen (20) in gleicher Weise angesteuert werden.

9. Anstriebselement nach Anspruch 6, dadurch gekennzeichnet, daß die Türmchen (41, 42) in der Weise angesteurert werden, daß sich benachbarte Türmchen (41, 42) gegenläufig bewegen.

10. Antriebselement nach Anspruch 1 oder 4, dadurch gekennzeichnet, daß der Schichtenstapel in Form eines Winkels ausgebildet ist, dessen Schenkel beide einen Teilbereich der Kontaktierungsschichten bilden und jeweils Elektroden (73,74) aufweisen, mittels derer in den Schenkeln durch den sekundären piezoelektrischen Effekt hervorgerufene, gegeneinander phasenverschobene Längsschwingungen angeregt werden, die die Spitze der Winkelstruktur in eine elliptische Bewegung versetzen .

11. Antriebselement nach Anspruch 1 oder 4, dadurch gekennzeichnet, daß die piezoelektrischen Schichten (10) in Stapeln nach Art von Türmchen (50) angeordnet sind, welche zinnenartig nebeneinander angeordnet sind, wobei nebeneinander angeordnete Türmchen (50) jeweils durch einen Brückenstapel (51) verbunden sind.

12. Antriebselement nach Anspruch 11, dadurch gekennzeichnet, daß Türmchen (50) und Brückenstapel (51) zu zueinander orthogonalen Längsschwingungen angeregt sind.

13. Antriebselement nach Anspruch 4, dadurch gekennzeichnet, daß die Fläche (801) der Elektrode verschieden ist von der Fläche des zweiten, nicht kontaktierten Teilbereiches.

14. Antriebselement nach Anspruch 1 oder 4, dadurch gekennzeichnet, daß an die Elektroden (801) eine Wechselspannung angelegt ist, deren Frequenz in oder nahe bei der Resonanzfrequenz für die durch die Wechselspannung angeregte Längsschwingung liegt.

15. Antriebselement nach Anspruch 1 oder 4, dadurch gekennzeichnet daß die Kontaktierungsschichten in drei nebeneinander liegende Teilbereiche (901, 902, 903) gegliedert sind, wobei an die äußeren Bereiche (901, 903) Wechselspannungen mit entgegengesetzter Polarität, an der mittleren eine Wechselspannung mit der zu einer gewünschten Bewegungsrichtung führenden Polarität angelegt sind.

16. Antriebselement nach Anspruch 1 oder 4, dadurch gekennzeichnet, daß an die Elektrode Wechselspannunen angelegt sind, welche sich jeweils durch Überlagerung zweier Wechselspannungen ergeben, deren Frequenzverhältnis zueinander ganzzahlig ist.

17. Antriebselement nach Anspruch 1 oder 4, dadurch gekennzeichnet daß der Schichtenstapel (20) so dimensioniert ist, daß zur gleichzeitigen Anregung von Biegeschwingungen und Längsschwingungen zwei verschiedenfrequente Wechselspannungen erforderlich sind.

18. Antriebselement nach Anspruch 1 oder 4, dadurch gekennzeichnet, daß übereinanderliegende piezoelektrische Schichten (10) ungleiche geometrische Formen aufweisen.

**Claims**

1. Ultrasonic drive element having a plurality of layers, arranged one above another to form a stack, made from piezoelectric material, between which there is located in each case one contacting layer divided into at least two sub-regions, each sub-region having in each case an electrode (13, 14, 15) which makes contact with the adjoining piezoelectric layers (10) and to which it is possible to apply in each case an operating AC voltage which excites a surface (21) of the layer stack to mechanical vibrations which include a movement component parallel to the plane of this surface, characterized in that there are applied at least to some of the electrodes (13, 14, 15) AC voltages which excite the layer stack to longitudinal vibrations (H).

2. Drive element according to Claim 1, characterized in that AC voltages are applied to some (34, 35, 37) of the piezoelectric layers (10) in order to excite longitudinal vibrations (H), and AC voltages are applied to the remaining ones (32, 33, 36, 38) in order to excite flexural vibrations (B).

3. Drive element according to Claim 1, characterized in that there are applied to the electrodes (101, 102) AC voltages ($U_1$, $U_2$) which are mutually phase-shifted and simultaneously excite longitudinal and flexural vibrations (H, B) in the layer stack (22, 24).

4. Ultrasonic drive element having a plurality of layers, arranged one above another to form a stack, made from piezoelectric material, between which there is located in each case a contacting layer for applying an operating voltage, the contacting layers (12) being divided into at least two sub-regions, of which one has an electrode (801) which makes contact with the adjoining piezoelectric layers (10), characterized in that the sub-regions are divided unequally, no electric contact is made with the respective second sub-region, and the electrode (801) is driven by means of an AC voltage which simultaneously excites in the stack a lifting movement (H) and a bending movement (B).

5. Drive element according to Claim 1, characterized in that the layer stack is subdivided into at least four regions (121, 122, 123, 124), there being applied to the electrodes of regions (121, 124; 122, 123) situated diagonally opposite one another in each case phase-shifted AC voltages (U3, U4) which excite the second mode of a flexural vibration in the layer stack.

6. Drive element according to Claim 1 or 4, characterized in that the piezoelectric layers (10) are arranged in stacks (20, 22, 24, 26) in the manner of towers (20) which are arranged next to one another like battlements on at least one common piezoelectric base layer (30) and are driven in a fashion tuned to one another.

7. Drive element according to Claim 6, characterized in that the towers (20) are arranged annularly.

8. Drive element according to Claim 6, characterized in that all the towers (20) are driven in the same way.

9. Drive element according to Claim 6, characterized in that the towers (41, 42) are driven in such a way that neighbouring towers (41, 42) move in opposite directions.

10. Drive element according to Claim 1 or 4, characterized in that the layer stack is constructed in the shape of an angle whose arms both form a sub-region of the contacting layers and in each case have electrodes (73, 74) by means of which there are excited in the arms mutually phase-shifted longitudinal vibrations which are caused by the secondary piezoelectric effect and set the apexes of the angular structure in elliptical motion.

11. Drive element according to Claim 1 or 4, characterized in that the piezoelectric layers (10) are arranged in stacks in the manner of towers (50) which are arranged next to one another like battlements, towers (50) arranged next to one another being connected in each case by a bridge stack (51).

12. Drive element according to Claim 11, characterized in that towers (50) and bridge stacks (51) are excited to mutually orthogonal longitudinal vibrations.

13. Drive element according to Claim 4, characterized in that the area (801) of the electrode differs from the area of the second sub-region, with which contact is not made.

14. Drive element according to Claim 1 or 4, characterized in that there is applied to the electrodes (801) an AC voltage whose frequency is at or near the resonant frequency for the longitudinal vibration excited by the AC voltage.

15. Drive element according to Claim 1 or 4, characterized in that the contacting layers are divided into three sub-regions (901, 902, 903) situated next to one another, there being applied to the outer regions (901, 903) AC voltages of opposing polarity, and to the middle one an AC voltage having the polarity leading to a desired direction of movement.

16. Drive element according to Claim 1 or 4, characterized in that there are applied to the electrode AC voltages which in each case result from the superimposition of two AC voltages whose mutual frequency ratio is an integer.

17. Drive element according to Claim 1 or 4, characterized in that the layer stack (20) is dimensioned such that two AC voltages of different frequency are required for simultaneously exciting flexural vibrations and longitudinal vibrations.

18. Drive element according to Claim 1 or 4, characterized in that piezoelectric layers (10) situated one above another have different geometrical shapes.

**Revendications**

1. Elément d'entraînement par ultrasons, avec plusieurs couches superposées sous la forme d'une pile, de matière piézo-électrique entre lesquelles il y a chaque fois une couche de contact répartie en au moins deux zones partielles et chaque zone partielle comporte chaque fois une électrode (13, 14, 15) en contact avec la couche piézo-électrique adjacente (10), cette électrode recevant respectivement une tension alternative de fonctionnement, pour exciter une surface supérieure (21) de la pile de couches pour des oscillations mécaniques qui concernent une composante de mouvement parallèle au plan de cette surface supérieure, caractérisé en ce qu' au moins sur une partie des électrodes (13, 14, 15) on applique des tensions alternatives qui excitent la pile de couches sur des oscillations longitudinales (H).

2. Elément d'entraînement selon la revendication 1, caractérisé en ce que sur une partie (34, 35, 37) des couches piézo-électriques (10), on applique des tensions alternées pour exciter les oscillations longitudinales (H) et sur les autres parties (32, 33, 36, 38) on applique des tensions alternatives pour exciter des oscillations de flexion (B).

3. Elément d'entraînement selon la revendication 1, caractérisé en ce qu' aux électrodes (101, 102) on applique des tensions alternatives ($U_1$, $U_2$) déphasées de manière opposée, et ces tensions excitent dans la pile de couche (22, 24) simultanément des oscillations longitudinales (H) et des oscillations de flexion (B).

4. Elément d'entraînement par ultrasons comportant plusieurs couches superposées en une pile de matière piézo-électrique, couches entre lesquelles il y a chaque fois une couche de contact pour appliquer une tension de fonctionnement, les couches de contact (12) étant subdivisée en au moins deux zones partielles dont l'une comporte l'électrode de contact avec la couche piézo-électrique adjacente (10), caractérisé en ce que les zones partielles sont subdivisées de manière irrégulière, et la seconde zone partielle n'est électriquement pas mise en contact et la commande de l'électrode 801 se fait avec une tension alternative qui excite dans la pile, simultanément un mouvement de translation (H) et un mouvement de flexion (B).

5. Elément d'entraînement selon la revendication 1, caractérisé en ce que la pile de couches est subdivisée en au moins quatre zones (121, 122, 123, 124), les électrodes étant reliées chaque fois à des zones (121, 124, 122, 123) diamétralement opposées, avec des tensions alternatives déphasées ($U_3$, $U_4$), et qui excitent

dans la pile de couche en second mode, une oscillation de flexion.

6. Elément d'entraînement selon la revendication 1 ou 4, caractérisé en ce que les couches piézo-électriques (10) des piles (20, 22, 24, 26) sont disposées à la manière de colonnes (20) elles mêmes placées en créneau sur au moins une couche de base piézo-électrique commune (30) et sont commandées de manière réciproque.

7. Elément d'entraînement selon la revendication 6, caractérisé en ce que les colonnes (20) sont réparties en forme d'anneaux.

8. Elément d'entraînement selon la revendication 6, caractérisé en ce que toutes les colonnes (20) sont commandées de la même manière.

9. Elément d'entraînement selon la revendication 6, caractérisé en ce que les colonnes (41, 42) sont commandées pour que les colonnes voisines (41,,42) se déplacent en sens opposé.

10. Elément d'entraînement selon la revendication 1 ou 4, caractérisé en ce que la pile de couche est réalisée sous la forme d'un angle dont les deux branches forment une zone partielle pour les couches de mise en contact et comportent des électrodes (73, 74) à l'aide desquelles, dans les branches on excite par l'effet piézo-électrique secondaire, des oscillations longitudinales déphasées réciproquement, et qui correspondent à la pointe de la structure d'angle dans un mouvement elliptique.

11. Elément d'entraînement selon la revendication 1 ou 4, caractérisé en ce que les couches piézo-électriques (10) sont prévues sous forme de piles en colonnes (50) disposées en créneau et les piles juxtaposées (50) sont chaque fois reliées par un empilage formant pont (51).

12. Elément d'entraînement selon la revendication 11, caractérisé en ce que les colonnes (50) et les empilages formant pont (51) sont excités l'un par l'autre suivant des oscillations longitudinales ou orthogonales.

13. Elément d'entraînement selon la revendication 4, caractérisé en ce que la surface (801) de l'électrode est différente de la surface de la seconde zone partielle non contactée.

14. Elément d'entraînement selon la revendication 1 ou 4,
caractérisé en ce qu'
une tension alternative est appliquée aux électrodes (801) dont la fréquence est au moins égale à la fréquence de résonance de l'oscillation longitudinale excitée par la tension alternative.

15. Elément d'entraînement selon la revendication 1 ou 4,
caractérisé en ce que
les couches de contact sont réparties en trois zones juxtaposées (901, 902, 903), les zones externes (901, 903) sont complètement soumises à la tension alternative à polarité opposée et la zone centrale reçoit une tension alternative avec une polarité conduisant à l'installation de déplacement souhaitée.

16. Elément d'entraînement selon la revendication 1 ou 4,
caractérisé en ce que
l'électrode reçoit les tensions alternatives qui résultent chaque fois de la combinaison de deux tensions alternatives et dont le rapport des fréquences est égal à un nombre entier.

17. Elément d'entraînement selon la revendication 1 ou 4,
caractérisé en ce que
la pile de couches (20) est dimensionnée pour exciter simultanément les oscillations propres et les oscillations longitudinales, il faut deux tensions alternatives différentes.

18. Elément d'entraînement selon la revendication 1 ou 4,
caractérisé en ce que
les couches piézo-électriques (10) ont des formes géométriques différentes.

FIG. 1

FIG. 2

# FIG. 2

c)

d)

# FIG. 3

# FIG. 4

# FIG. 5

a)

b)

c)

d)

# FIG. 6

FIG.7

a)

b)

# FIG. 8

a)

b)

c)

d)

# FIG. 9

901  902  903  21

12

10

$U_L$  $U_M$  $U_R$

# FIG. 10

a)  b)  c)  d)

12  12  12  12

# FIG. 11

111

112

113

FIG. 4d

FIG. 4e

FIG. 12

FIG.4f